(19) Europäisches Patentamt
European Patent Office
Office européen des brevets

(11) EP 4 614 163 A1

(12) EUROPEAN PATENT APPLICATION
published in accordance with Art. 153(4) EPC

(43) Date of publication:
10.09.2025 Bulletin 2025/37

(51) International Patent Classification (IPC):
*G01R 15/20* (2006.01)

(21) Application number: 23883888.2

(22) Date of filing: 29.08.2023

(52) Cooperative Patent Classification (CPC):
G01R 15/207; G01R 1/18; G01R 15/20;
G01R 15/205

(86) International application number:
PCT/JP2023/031292

(87) International publication number:
WO 2024/095585 (10.05.2024 Gazette 2024/19)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 02.11.2022 JP 2022176153

(71) Applicant: Alps Alpine Co., Ltd.
Tokyo 145-8501 (JP)

(72) Inventors:
• TAMURA, Manabu
  Tokyo 145-8501 (JP)
• KUMAGAI, Yuu
  Tokyo 145-8501 (JP)
• UEDA, Chiaki
  Tokyo 145-8501 (JP)

(74) Representative: Maiwald GmbH
Engineering
Elisenhof
Elisenstrasse 3
80335 München (DE)

(54) CURRENT SENSOR

(57) A current sensor 1 according to the present invention includes a busbar 11, a magnetic detector 12 capable of detecting a magnetic field generated when a current to be measured flows through the busbar 11, and a magnetic shield 13 capable of suppressing external magnetic field noise applied to the magnetic detector 12. The busbar 11 extends in an X-axis direction. The magnetic detector 12 is disposed on a Y1 side of a Y-axis direction perpendicular to a plate surface of the busbar 11 in such a way as to face the busbar 11. When viewed in the X-axis direction, the magnetic shield 13 has a U-shape including a bottom 131 that is disposed on a Y2 side of the Y-axis direction in such a way as to face the busbar 11 and that extends in a Z-axis direction and side walls 132 extending from both ends of the bottom 131 in the Z-axis direction to the Y1 side of the Y-axis direction. The busbar 11 is disposed between the pair of side walls 132. A first dimension T1 of the bottom 131 is larger than a second dimension T2 of the side walls 132. As a result, deterioration of a frequency characteristic of the magnetic shield due to eddy current generated when the current to be measured flows is reduced.

FIG. 1

## Description

Technical Field

The present invention relates to a current sensor that detects a magnetic field generated by a current to be measured flowing through a busbar and that measures a current value of the current to be measured from the detected magnetic field.

Background Art

During these years, current sensors that are attached to various devices and that measure currents to be measured flowing through the various devices are used to control and monitor the various devices. As such current sensors, current sensors employing a magnetoelectric conversion element, which detects a magnetic field generated when a current to be measured flows through a current path, such as a magnetoresistive element or a Hall element, are widely known. In order to improve measurement accuracy of these current sensors, a magnetic shielding member that reduces an effect of external magnetic fields is used.

PTL 1 describes a current sensor that is intended for downsizing while maintaining a high magnetic shielding effect and that includes a current path and a magnetoelectric conversion element which detects a magnetic field generated when a current to be measured flows through the current path, in which an internal magnetic shielding member surrounding at least a part of the current path and the magnetoelectric conversion element and an external magnetic shielding member surrounding at least a part of the internal magnetic shield member.

PTL 2 describes a current detection device that is intended for downsizing while accurately detecting a current and that includes a sensor unit including a current path, a magnetic shielding section surrounding the current path, and three magnetic detection elements which detect a current flowing through the current path, and a housing in which a storage chamber which accommodates the sensor unit is integrally formed.

Citation List

Patent Literature

PTL 1: Japanese Unexamined Patent Application Publication No. 2014-98633
PTL 2: Japanese Unexamined Patent Application Publication No. 2016-6399

Summary of Invention

Technical Problem

Since the current sensor (current detection device) according to PTL 1 and PTL 2 includes a magnetic shielding member surrounding a current path, eddy current is generated in the magnetic shielding member due to a change in a magnetic field at a time when a current to be measured flows through the current path. There is a problem in that the eddy current deteriorates a frequency characteristic of the current sensor.

The present invention, therefore, aims to provide a current sensor in which deterioration of a frequency characteristic due to eddy current in a magnetic shield generate when a current to be measured flows is reduced.

Solution to Problem

The present invention includes the following configuration as means for solving the above-described problem.

A current sensor includes a busbar through which a current to be measured flows, a magnetic detector capable of detecting a magnetic field generated when the current to be measured flows through the busbar, and a magnetic shield capable of suppressing external magnetic field noise applied to the magnetic detector. When a direction in which the busbar extends is a first direction and two directions perpendicular to the first direction and to each other are a second direction and a third direction, the magnetic detector is disposed on one side of the second direction perpendicular to a plate surface of the busbar in such a way as to face the busbar. When viewed in the first direction, the magnetic shield has a U-shape including a bottom that is disposed on another side of the second direction in such a way as to face the busbar and that extends in the third direction and side walls extending from both ends of the bottom in the third direction to the one side of the second direction. In the current sensor in which the busbar is disposed between the pair of side walls, a first dimension of the bottom in the second direction is larger than a second dimension of the side walls in the third direction when the magnetic shield is viewed in the first direction.

Since the first dimension of the bottom of the magnetic shield is larger than the second dimension of the side walls in the configuration, an eddy current loss caused when the current to be measured flows through the busbar can be suppressed, and deterioration of a frequency characteristic of the current sensor can be reduced.

The first dimension is preferably larger than the second dimension, and is 2.0 times or less larger than the second dimension.

With this configuration, the eddy current loss caused in the magnetic shield when the current to be measured flows through the busbar can be suppressed, and the magnetic shield can be reduced in size.

The magnetic shield may have a configuration in which reference plates, which are flat plates whose outer shapes are a U-shape, are stacked on one another in the first direction such that the outer shapes match.

With this configuration, since the reference plates are formed in outer shapes that match a shape of the magnetic shield and stacked on one another, a magnetic shield in which the first dimension of the bottom is larger than the second dimension of the side walls can be easily formed.

Insulating layers may be provided between the adjacent reference plates.

By providing insulating layers between the adjacent reference plates, electrical resistance of a path of the eddy current generated in the magnetic shield increases, and the eddy current loss can be suppressed.

The magnetic shield may include a first magnetic shield plate bent into a U-shape and a second magnetic shield plate formed in a flat plate shape, and the first magnetic shield plate and the second magnetic shield plate may be stacked on each other on the bottom.

By forming the bottom by stacking the second magnetic shield plate formed in a flat plate shape on a part of the first magnetic shield plate with uniform thickness bent into a U-shape, a magnetic shield in which the first dimension of the bottom is larger than the second dimension of the side walls can be easily formed.

Advantageous Effects of Invention

According to the present invention, it is possible to reduce deterioration of a frequency characteristic of a current sensor due to eddy current generated in a magnetic shield as a result of a change in a magnetic field caused when a current to be measured flows. A current sensor with excellent measurement accuracy, therefore, can be provided.

Brief Description of Drawings

[Fig. 1] Fig. 1 is a perspective view of a current sensor according to a first embodiment.
[Fig. 2A] Fig. 2A is a cross-sectional view of the current sensor taken along line A-A in Fig. 1.
[Fig. 2B] Fig. 2B is a cross-sectional view of a magnetic shield in the current sensor in Fig. 2A.
[Fig. 3] Fig. 3 is a perspective view of a modification of the magnetic shield in Fig. 2B and reference plates.
[Fig. 4] Fig. 4 is a cross-sectional view of another modification of the magnetic shield in Fig. 2B.
[Fig. 5] Fig. 5 is a perspective view of a current sensor according to a second embodiment.
[Fig. 6] Fig. 6 is a cross-sectional view of the current sensor taken along line A-A in Fig. 5.
[Fig. 7A] Fig. 7A is a graph illustrating frequencies and phase characteristics in an example and a comparative example.
[Fig. 7B] Fig. 7B is a graph illustrating the frequencies and gain characteristics in the example and the comparative example.
[Fig. 8] Fig. 8 is a graph illustrating a ratio (T1/T2) of dimensions of a magnetic shield, the phase characteristics, and the gain characteristics in the example and the comparative example.
[Fig. 9] Fig. 9 is a perspective view schematically illustrating generation of eddy current in the magnetic shield.
[Fig. 10] Fig. 10 is a cross-sectional view of a conventional current sensor.
[Fig. 11] Fig. 11 is a perspective view illustrating a result of a simulation of eddy current generated in a magnetic shield of the conventional current sensor.

Description of Embodiments

Embodiments of the present invention will be described hereinafter with reference to the accompanying drawings. In the drawings, the same members are given the same numerals, and description thereof is omitted. Reference coordinates are shown in each drawing as appropriate in order to indicate positional relationships between members. In the reference coordinates, a direction in which a busbar extends is an X-axis direction (first direction), a direction of a perpendicular to a plate surface of the busbar is a Y-axis direction (second direction), and a direction on the plate surface of the busbar perpendicular to the direction in which the busbar extends is a Z-axis direction (third direction). The Y-axis direction and the Z-axis direction are perpendicular to the X-axis direction and to each other.

[First Embodiment]

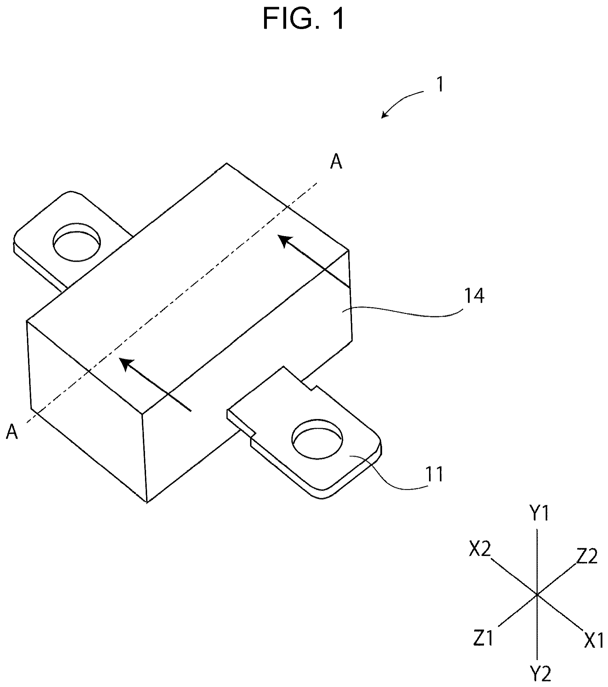

Fig. 1 is a perspective view of a current sensor 1 according to the present embodiment.

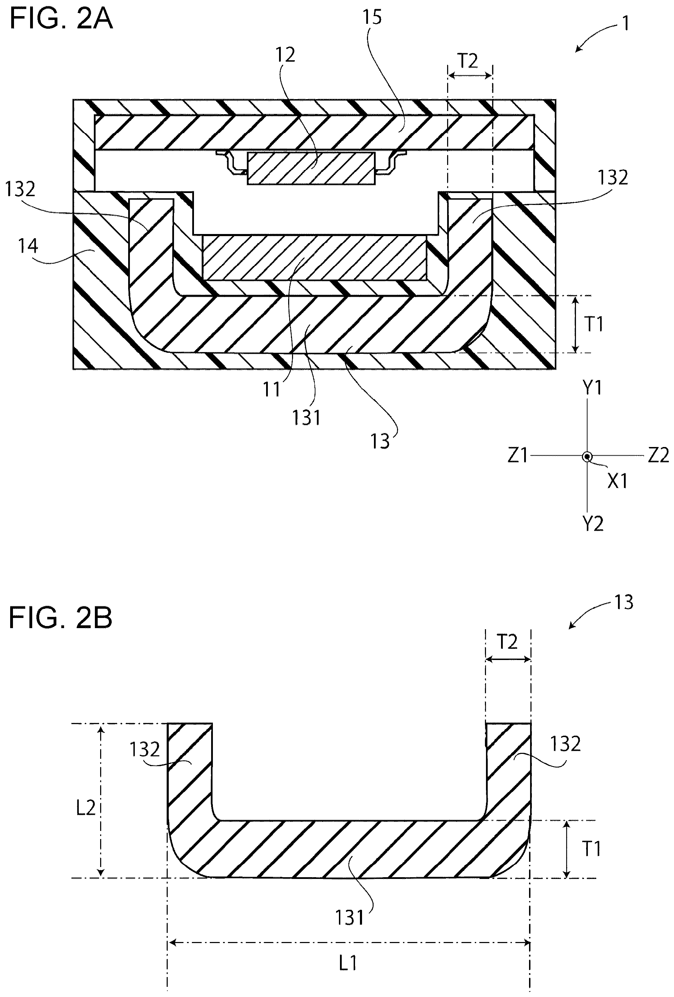

Fig. 2A is a cross-sectional view illustrating a cross section along line A-A in Fig. 1, and Fig. 2B is a cross-sectional view illustrating only a magnetic shield 13 of the current sensor 1 in Fig. 2A.

The current sensor 1 includes a busbar 11, a magnetic detector 12, and the magnetic shield 13.

The busbar 11 is a conductive material formed in a plate shape, and two opposing plate surfaces thereof are provided in correspondence with upper and lower sides (both sides in the Y-axis direction) of a case 14. The busbar 11 is made of copper, brass, aluminum, or the like, and a current to be detected and measured flows through the busbar 11. The busbar 11 is held in the case 14, and a part of the busbar 11 is integrally formed with the case 14 through insert molding.

Both ends of the busbar 11 in the X-axis direction, which serve as connectors to the outside, need not necessarily be line-symmetrical with respect to an X-axis. In addition, a part of the busbar 11 facing the magnetic detector 12 may be smaller in a dimension thereof in the Z-axis direction than other parts of the busbar 11. The parts of the busbar 11 other than the part facing the magnetic detector 12 need not be flat, and, for example, may be bent.

The magnetic detector 12 is capable of detecting a magnetic field generated when the current to be measured flows through the busbar 11, and a magnetoresistive element, a Hall element, or the like may be used as a detection element. Note that the present embodiment assumes a case where a magnetoresistive element is used as the detection element. The magnetic detector 12 is separated from the busbar 11 in the Y-axis direction, and disposed in such a way as to face the plate surface of the busbar 11 on a Y1 side of the Y-axis direction. In the present embodiment, a surface of the magnetic detector 12 on a Y2 side is a detection surface capable of detecting a magnetic field, and can detect a magnetic component in a sensitivity axis direction parallel to the detection surface. The magnetic detector 12 is provided on a surface, on the Y2 side, of a board 15, which is disposed on the Y1 side of the magnetic detector 12, such that the sensitivity axis direction becomes perpendicular to a direction of the current to be detected flowing through the busbar (the sensitivity axis direction is the Z-axis direction). The board 15 is made of, for example, epoxy glass, ceramic, or the like.

In Fig. 2A, the center of the magnetic detector 12 in width in the Z-axis direction and the center of the busbar 11 in width in the Z-axis direction coincide with each other when viewed in the X-axis direction. The magnetic detector 12, however, may be at any position from which a magnetic field generated when the current to be measured flows through the busbar 11 can be measured. The magnetic detector 12, therefore, need not entirely overlap the busbar 11, and may be disposed at a shifted position. For example, even if the magnetic detector 12 is disposed at a position shifted to the Z2 side from a position illustrated in Fig. 2A and does not overlap the busbar 11 when viewed in the Y-axis direction, it is sufficient that the magnetic detector 12 be at a position from which a magnetic field generated when the current to be measured flows through the busbar 11 can be measured. A part of the magnetic detector 12, however, preferably overlaps the opposing busbar 11 when viewed in the Y-axis direction.

Note that although the magnetic detector 12 is not located between side walls 132 of the magnetic shield 13 in Fig. 2A, the magnetic detector 12 may be disposed between the side walls 132, instead. That is, the magnetic detector 12 may be disposed at a position where the magnetic detector 12 overlaps the side walls 132 when viewed in the Z-axis direction. By disposing the magnetic detector 12 between the side walls 132, the magnetic shield 13 can effectively suppress external magnetic fields for the magnetic detector 12.

When viewed in the X-axis direction, the magnetic shield 13 has a U-shape including a bottom 131 and the two side walls 132 extending to the Y1 side from both ends of the bottom 131.

The bottom 131 is a flat plate having a plate surface parallel to an XZ plane, extends in the Z-axis direction, and faces the busbar 11 from the Y2 side of the Y-axis direction.

The side walls 132 are flat plates having plate surfaces parallel to an XY plane and extend from both ends of the bottom 131 in the Z-axis direction to the Y1 side of the Y-axis direction.

The magnetic shield 13 is, for example, a plurality of metal plates having the same shape and stacked on one another. Because the magnetic shield 13 can reduce external magnetic field noise applied to the magnetic detector 12 by blocking the external magnetic field noise, external magnetic field noise resistance of the magnetic detector 12 improves.

The current sensor 1 is used, for example, to measure currents flowing into and out of a battery in a BMS (battery management system) that monitors a battery charge level or the like. In this case, emphasis is placed on high accuracy. In the current sensor 1, therefore, a U-shaped magnetic shield 13, which effectively protects the magnetic detector 12 from external magnetic fields, is provided.

The bottom 131 of the magnetic shield 13, the busbar 11, and the magnetic detector 12 are arranged in this order from the Y2 side to the Y1 side of the Y-axis direction. The busbar 11 is provided between the two side walls 132 of the magnetic shield 13 in the Z-axis direction. As a result, eddy current is generated in the magnetic shield 13 by an induced magnetic field generated by the current to be measured flowing through the busbar 11.

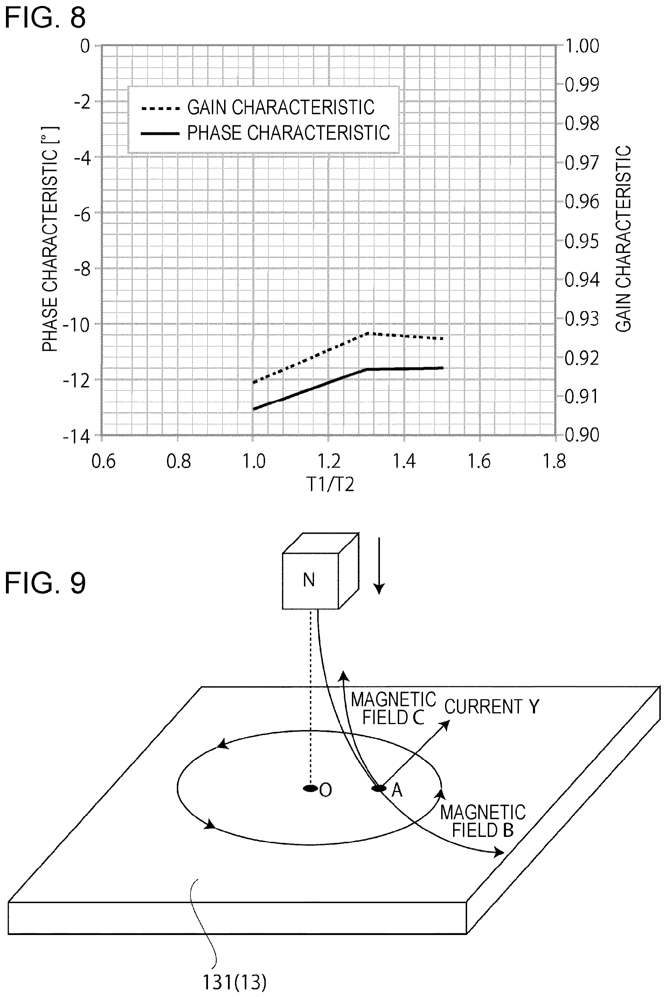

Fig. 9 is a perspective view schematically illustrating the eddy current generated in the magnetic shield 13 at a time when the current to be measured flows through the busbar 11 (refer to Fig. 2A). The eddy current generated in the magnetic shield 13 as a result of a change in the magnetic field will be described with reference to the drawing, which illustrates a part of the bottom 131 of the magnetic shield 13. When a magnet N is brought closer to the magnetic shield 13, a magnetic field C is generated at a point A in a direction in which a magnetic field B increased by the movement of the magnet N is reduced. As a result of the generation of the magnetic field C, a current Y is generated at the point A in a direction indicated by an arrow. As a result of the change in the magnetic field, a current such as the current Y indicated by the arrow is generated at every point on the magnetic shield 13. When the magnetic shield 13 is viewed as a whole, therefore, eddy current flowing counterclockwise about an intersection O between a perpendicular from the magnet N and the magnetic shield 13 is generated.

When the current to be measured flows through the busbar 11, an induced magnetic field is generated, which causes a change in the magnetic field in the magnetic shield 13 and generates eddy current. This eddy current deteriorates a frequency characteristic of the current sensor 1. From the perspective of obtaining a current sensor 1 with excellent measurement accuracy, it is preferable to reduce an eddy current loss as much as possible.

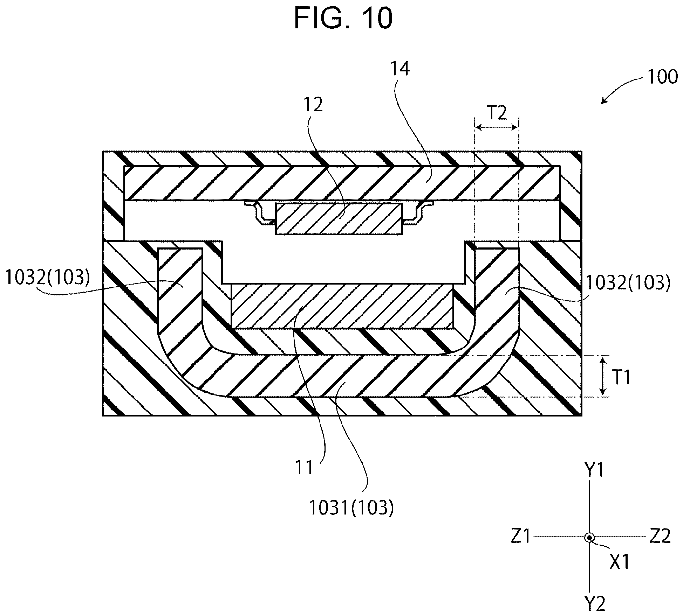

Fig. 10 is a cross-sectional view of a conventional current sensor 100, and illustrates a cross section corresponding to a part indicated by line A-A in the current sensor 1 of Fig. 1. Because a U-shaped magnetic shield 103 is fabricated by bending a single plate, a first dimension T1 of a bottom 1031 in the Y-axis direction and a second dimension T2 of side walls 1032 in the Z-axis direction are the same. A simulation of magnetic flux density caused in the magnetic shield 103 when a current to be measured flows through the busbar 11 was conducted in the conventional current sensor 100 including the U-shaped magnetic shield 103 in which the first dimension T1 and the second dimension T2 were the same.

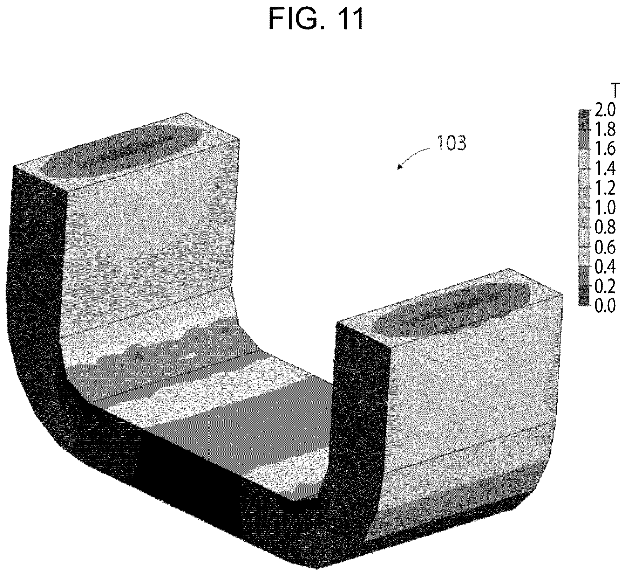

Fig. 11 is a perspective view illustrating a simulation result. It was found from the simulation result illustrated in the drawing that, in the U-shaped magnetic shield 103, the magnetic flux density caused when the current to be measured flowed through the busbar 11 was higher in the bottom 1031 than in the side walls 1032.

The eddy current loss in the magnetic shield 103 is expressed by the following Expression (1), and a square of a maximum magnetic flux density affects the eddy current loss.

[Math. 1]

$$P_e = K_e(fB_M t)^2 V[\mathbf{W}]\quad (1)$$

$P_e$: eddy current loss (W), $K_e$: constant of proportionality, f: frequency (Hz), $B_M$: maximum magnetic flux density (T), t: thickness of magnetic shield (m), V: volume of magnetic shield ($m^3$)

In the current sensor 1, therefore, the first dimension T1 of the bottom 131, where the magnetic flux density becomes high, is made larger than the second dimension T2 of the side walls 132 as illustrated in Figs. 2A and 2B from the perspective of reducing the effect of the eddy current loss. Because a magnetic flux concentrating effect upon the magnetic field generated when the current to be measured flows through the busbar 11 becomes large if the second dimension T2 of the side walls 132 is increased, only the first dimension T1 of the bottom 131, where the magnetic flux density becomes high, is increased. By employing a U-shaped magnetic shield 13 in which the first dimension T1 of the bottom 131 in the Y-axis direction is larger than the second dimension T2 of the side walls 132 in the Z-axis direction, deterioration of the frequency characteristic of the current sensor 1 can be reduced.

From the perspective of suppressing the effect of the eddy current generated in the magnetic shield 13 when the current to be measured flows through the busbar 11, the first dimension T1 is preferably larger than the second dimension T2 and 2.0 times or less larger than the second dimension T2, more preferably 1.1 times or more and 1.6 times or less larger than the second dimension T2, and even more preferably 1.2 times or more and 1.4 times or less larger than the second dimension T2.

With the above configuration, deterioration of the frequency characteristic of the current sensor 1 can be suppressed.

In the U-shape of the magnetic shield 13, for example, a longitudinal dimension L1 of an outer shape in the Z-axis direction may be 1 time or more and 4 times or less larger than, or more preferably 1.5 times or more and 3 times or less larger than a lateral dimension L2 of an outer shape in the Y-axis direction.

<Modifications>

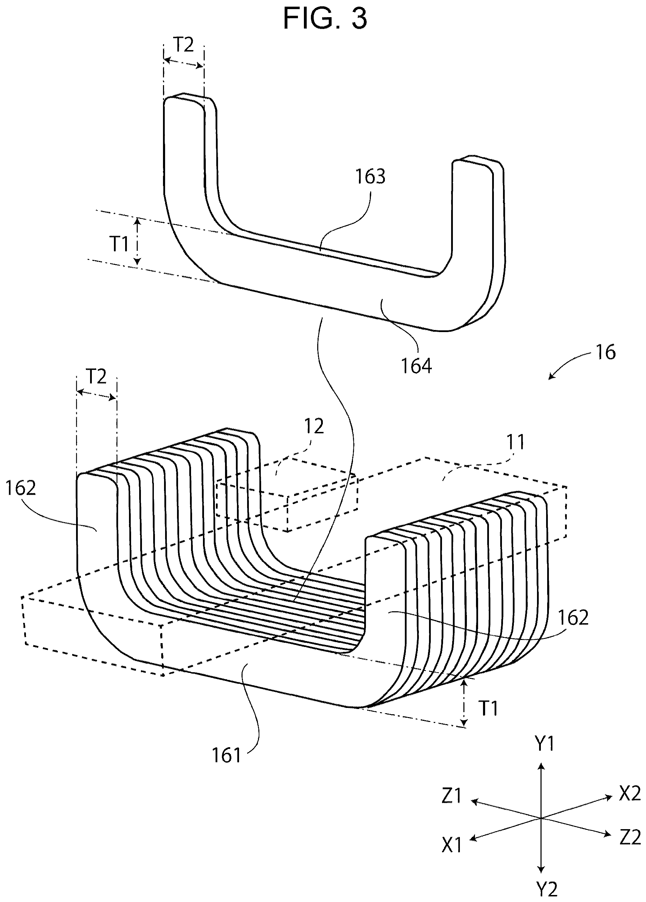

Fig. 3 is a perspective view of a magnetic shield 16 as a modification of the magnetic shield 13 illustrated in Fig. 2B, and one of reference plates 163 constituting the magnetic shield 16. As illustrated in the drawing, the reference plate 163 is a flat plate whose outer shape is a U-shape when viewed in the X-axis direction. The magnetic shield 16 is obtained by stacking the reference plates 163 on one another in the X-axis direction such that outer shapes of the reference plates 163 match.

A U-shaped magnetic shield whose thickness varies depending on a portion cannot be formed just by bending a plate with uniform thickness. For this reason, for example, thickness of side walls needs to be reduced or thickness of a bottom needs to be increased after the plate is bent. In addition, spring back of a bent portion of the plate might occur. It is therefore difficult to form a U-shaped magnetic shield whose thickness differs between a bottom and sidewalls from a plate with uniform thickness.

The magnetic shield 16 illustrated in Fig. 3, therefore, is formed by stacking the reference plates 163 on one another. The reference plates 163 constituting the magnetic shield 16 can easily have a predetermined outer shape by, for example, punching metal plates into a U-shape through pressing. That is, it is easy to make the first dimension T1 of a bottom 161 different from the second dimension T2 of side walls 162. Unlike when a magnetic shield is formed by bending a single plate through sheet metal processing, press processing, or the like, spring back does not occur in the reference plates 163, and a shape thereof is stable. By stacking the reference plates 163 having the predetermined outer shape on one another, therefore, a magnetic shield 16 with the predetermined first dimension T1 of the bottom 161 and the predetermined second dimension T2 of the side walls 162 can be easily formed.

Insulating layers 164 may also be provided between the reference plates 163 constituting the magnetic shield 16. Since the insulating layers 164 are provided between the reference plates 163, the eddy current can be further suppressed. That is, because electrical resistance of a path of the eddy current generated in the magnetic shield 16 increases due to the insulating layers 164 insulating the adjacent reference plates 163 from each other, the eddy current generated when the current to be measured flows through the busbar 11 can be suppressed.

Note that it is sufficient that the insulating layers 164 be provided in such a way as to insulate the adjacent reference plates 163 from each other. For example, by stacking the reference plates 163 including the insulating layers 164 formed only on surfaces thereof on an X1 side of the X-axis direction on one another, the adjacent reference plates 163 can be insulated from each other. Alternatively, a reference plate 163 including insulating layers 164 formed on both sides thereof on the X1 side and an X2 side of the X-axis direction and a reference plate 163 including no insulating layers 164 may be stacked on each other alternately.

As described above, by stacking the reference plates 163 on one another, a magnetic shield 16 having a shape with which generation of eddy current can be suppressed can be easily formed. In addition, since the magnetic shield 16 does not cause spring back, the shape thereof can be maintained stably.

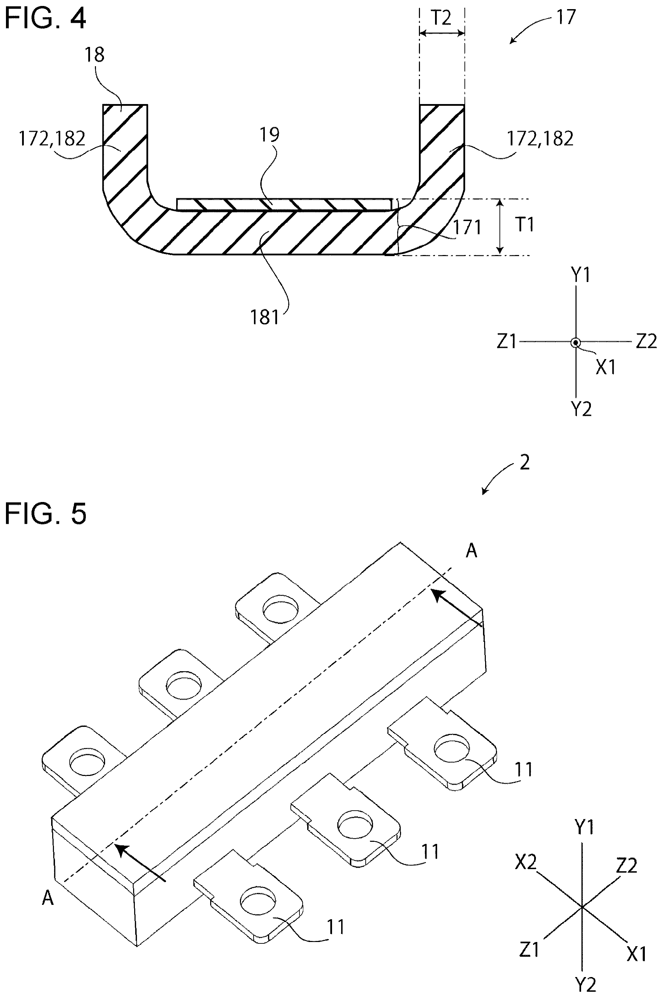

Fig. 4 is a cross-sectional view of a magnetic shield 17 as another modification of the magnetic shield 13 of Fig. 2B.

As illustrated in the drawing, the magnetic shield 17 includes a first magnetic shield plate 18 bent into a U-shape and a second magnetic shield plate 19 formed in a flat plate shape.

The first magnetic shield plate 18 includes a base 181 and opposing portions 182 extending from both ends of the base 181 in a direction intersecting with a surface of the base 181. The two opposing portions 182 face each other in the Z-axis direction. The second magnetic shield plate 19 is stacked on the base 181 of the first magnetic shield plate 18. The first magnetic shield plate 18 and the second magnetic shield plate 19 are thus stacked on each other at a bottom 171 of the magnetic shield 17.

By using the first magnetic shield plate 18 obtained by bending a plate with uniform thickness into a U-shape and the second magnetic shield plate 19 formed in a flat plate shape, a magnetic shield 17 having different dimensions in the bottom 171 and the side walls 172 can be easily formed. In addition, a ratio of the first dimension T1 of the bottom 171 to the second dimension T2 of the side walls 172 can be adjusted with thickness of the second magnetic shield plate 19 stacked on the base 181 of the first magnetic shield plate 18.

Fig. 4 illustrates a configuration in which the second magnetic shield plate 19 is provided on an inner surface (the Y1 side of the Y-axis direction) of the base 181 of the first magnetic shield plate 18. The second magnetic shield plate 19, however, may be provided on an outer surface (the Y2 side of the Y-axis direction) of the base 181 of the first magnetic shield plate 18, instead. Note that it is sufficient that the second magnetic shield plate 19 be stacked on at least a part of the base 181 of the first magnetic shield plate 18, but the second magnetic shield plate 19 may be stacked on the entirety of the base 181.

Note that the first magnetic shield plate 18 and the second magnetic shield plate 19 may each have a single-layer configuration or a multilayer configuration.

[Second Embodiment]

Fig. 5 is a perspective view of a current sensor 2 as a modification of the current sensor 1.

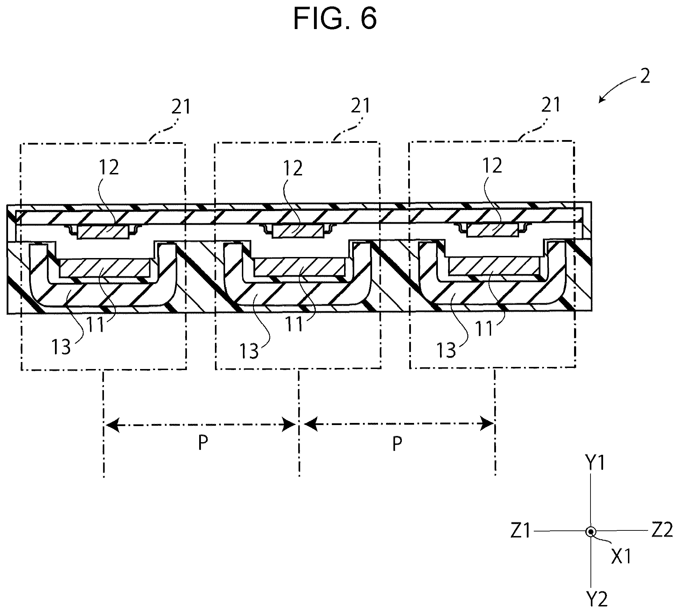

Fig. 6 is a cross-sectional view taken along line A-A in Fig. 5.

As illustrated in these drawings, the current sensor 2 according to the present embodiment is different from the current sensor 1 in that the current sensor 2 is of a multiphase type, that is, the current sensor 2 includes a plurality of measurement phases 21 each including a busbar 11, a magnetic detector 12, and a magnetic shield 13.

The U-shaped magnetic shield 13 is advantageous in downsizing the current sensor 2 of the multiphase type, because distances P between the busbars 11 in the measurement phases 21 can be made smaller than in a magnetic shield of a flat plate type. The U-shaped magnetic shield 13, however, has a problem in that the frequency characteristic of the current sensor 2 tends to deteriorate due to the eddy current generated when the current to be measured flows through the busbar 11.

The current sensor 2, therefore, makes the first dimension T1 of the bottom 131 of the U-shaped magnetic shield 13 larger than the second dimension T2 of the side walls 132 (refer to Fig. 2B). As a result, the eddy current generated in the magnetic shield 13 when the current to be measured flows through the busbar 11 can be suppressed, and deterioration of the frequency characteristic of the current sensor 2 can be reduced. It is therefore possible to reduce deterioration of the frequency characteristic and downsize the current sensor 2 of the multiphase type.

[Examples]

<Example 1>

In this example, a relationship between a frequency of a current to be measured flowing through the busbar 11, a phase characteristic, and a gain characteristic was simulated for the current sensor 1 illustrated in Fig. 2A including the magnetic shield 13 in which the first dimension T1 of the bottom 131 was larger than the second dimension T2 of the side walls 132. In the magnetic shield 13, T1 = 2.6 mm, T2 = 2.0 mm, L1 = 13 mm, and L2 = 7 mm.

As Comparative Example 1, a simulation was conducted, under the same conditions as in the example, for the current sensor 100 illustrated in Fig. 10 including the magnetic shield 103 in which the first dimension T1 of the bottom 1031 and the second dimension T2 of the side walls 1032 are the same. In the magnetic shield 103, T1 = 2.0 mm, T2 = 2.0 mm, L1 = 13 mm, and L2 = 6.4 mm.

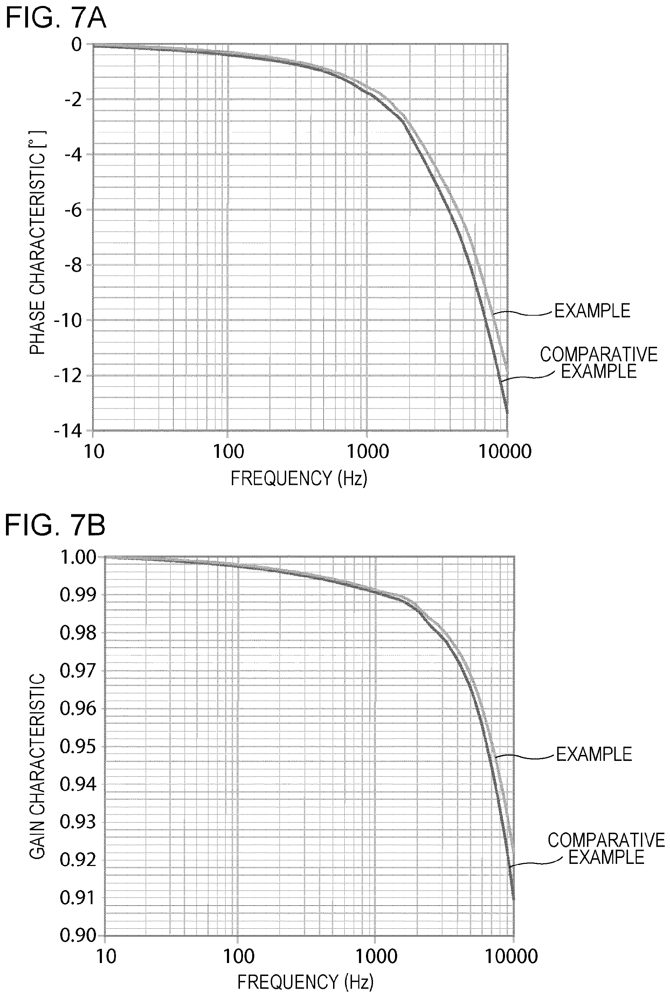

Figs. 7A and 7B are graphs indicating results of the simulations of the phase characteristic and the gain characteristic in the example and the comparative example. As illustrated in these drawings, the current sensor 1 in the example suppressed deterioration of the phase characteristic and the gain characteristic caused by an increase in the frequency more effectively than the current sensor 100 in the comparative example.

It was found from these results that a decrease in a frequency characteristic of a current sensor due to an effect of an eddy current loss could be suppressed by using the magnetic shield 13, in which the first dimension T1 of the bottom 131 was larger than the second dimension T2 of the side walls 132.

<Example 2>

A simulation of the phase characteristic and the gain characteristic was conducted as in Example 1 while setting the frequency of the current to be measured to 1,200 Hz and a ratio T1/T2 of T1 and T2 of the magnetic shield to 1.0 (Comparative Example 1), 1.3, and 1.5 in the current sensor 1 in Example 1.

Fig. 8 is a graph indicating a result of the simulation of the phase characteristic and the gain characteristic in this example. As illustrated in the drawing, by making T1/T2 larger than 1.0, the phase characteristic and the gain characteristic of the current sensor 1 improved.

The phase characteristic and the gain characteristic significantly improved by setting T1/T2 to 1.3, compared to when T1/T2 is 1.0. When T1/T2 was 1.5, however, further improvement in the phase characteristic and the gain characteristic was not observed compared to when T1/T2 was 1.3. This result means that T1/T2 is preferably 1.2 or more and 1.4 or less from the perspective of improving the frequency characteristic without increasing the magnetic shield in size.

Industrial Applicability

The present invention is useful as a current sensor that includes a busbar and that is used to measure currents flowing into and out of a battery in a BMS that monitors a battery charge level or the like.

Reference Signs List

1 current sensor

2 current sensor
11 busbar
12 magnetic detector
13 magnetic shield
14 case
15 board
16 magnetic shield
17 magnetic shield
18 first magnetic shield plate
19 second magnetic shield plate
21 measurement phases
100 current sensor
103 magnetic shield
131 bottom
132 side walls
161 bottom
162 side walls
163 reference plates
164 insulating layers
171 bottom
172 side walls
181 base
182 opposing portions
1031 bottom
1032 side walls
T1 first dimension
T2 second dimension
P distances
O intersection
A point
B magnetic field
C magnetic field
L1 longitudinal dimension
L2 lateral dimension
N magnet
Y current

**Claims**

1. A current sensor comprising:

a busbar through which a current to be measured flows;
a magnetic detector capable of detecting a magnetic field generated when the current to be measured flows through the busbar; and
a magnetic shield capable of suppressing external magnetic field noise applied to the magnetic detector,
wherein, when a direction in which the busbar extends is a first direction and two directions perpendicular to the first direction and to each other are a second direction and a third direction,
the magnetic detector is disposed on one side of the second direction perpendicular to a plate surface of the busbar in such a way as to face the busbar,

wherein, when viewed in the first direction, the magnetic shield has a U-shape including a bottom that is disposed on another side of the second direction in such a way as to face the busbar and that extends in the third direction and side walls extending from both ends of the bottom in the third direction to the one side of the second direction, and

wherein, in the current sensor in which the busbar is disposed between the pair of side walls, a first dimension of the bottom in the second direction is larger than a second dimension of the side walls in the third direction when the magnetic shield is viewed in the first direction.

2. The current sensor according to Claim 1, wherein the first dimension is larger than the second dimension, and is 2.0 times or less larger than the second dimension.

3. The current sensor according to Claim 1, wherein the magnetic shield has a configuration in which reference plates, which are flat plates whose outer shapes are a U-shape, are stacked on one another in the first direction such that the outer shapes match.

4. The current sensor according to Claim 3, wherein insulating layers are provided between the adjacent reference plates.

5. The current sensor according to Claim 1,

wherein the magnetic shield includes a first magnetic shield plate bent into a U-shape and a second magnetic shield plate formed in a flat plate shape, and

wherein the first magnetic shield plate and the second magnetic shield plate are stacked on each other on the bottom.

# FIG. 1

## FIG. 2A

## FIG. 2B

# FIG. 3

## FIG. 4

## FIG. 5

# FIG. 6

FIG. 7A

FIG. 7B

## FIG. 8

## FIG. 9

# FIG. 10

FIG. 11

# EP 4 614 163 A1

<table>
<tr><td colspan="2" style="text-align:center"><strong>INTERNATIONAL SEARCH REPORT</strong></td><td>International application No.<br><br><strong>PCT/JP2023/031292</strong></td></tr>
</table>

| A. | CLASSIFICATION OF SUBJECT MATTER |
|---|---|

*G01R 15/20*(2006.01)i
FI:   G01R15/20 C

According to International Patent Classification (IPC) or to both national classification and IPC

| B. | FIELDS SEARCHED |
|---|---|

Minimum documentation searched (classification system followed by classification symbols)

   G01R15/20

Documentation searched other than minimum documentation to the extent that such documents are included in the fields searched

   Published examined utility model applications of Japan 1922-1996
   Published unexamined utility model applications of Japan 1971-2023
   Registered utility model specifications of Japan 1996-2023
   Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2016-164523 A (TAMURA SEISAKUSHO KK) 08 September 2016 (2016-09-08)<br>paragraphs [0045]-[0046], [0053], fig. 8(a)-8(c) | 1, 2, 5 |
| X | JP 2013-148512 A (AISIN SEIKI CO LTD) 01 August 2013 (2013-08-01)<br>paragraphs [0023]-[0050], fig. 1-7 | 1-3 |
| Y | | 4 |
| Y | JP 2003-181968 A (TOSHIBA ELECTRONIC ENGINEERING CORP) 03 July 2003 (2003-07-03)<br>paragraphs [0002]-[0004] | 4 |
| A | JP 2014-202480 A (DENSO CORPORATION) 27 October 2014 (2014-10-27)<br>entire text, all drawings | 1-5 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 October 2023** | **31 October 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/031292**

| Patent document cited in search report | | | Publication date (day/month/year) | Patent family member(s) | | | Publication date (day/month/year) |
|---|---|---|---|---|---|---|---|
| JP | 2016-164523 | A | 08 September 2016 | CN paragraphs [0092]-[0094], [0102], fig. 8(a)-8(c) CN | 105938154 205608062 | A U | |
| JP | 2013-148512 | A | 01 August 2013 | US paragraphs [0021]-[0046], fig. 1-7 CN | 2013/0187633 203054064 | A1 U | |
| JP | 2003-181968 | A | 03 July 2003 | (Family: none) | | | |
| JP | 2014-202480 | A | 27 October 2014 | WO entire text, all drawings | 2014/162687 | A1 | |

Form PCT/ISA/210 (patent family annex) (January 2015)

**EP 4 614 163 A1**

**Patent documents cited in the description**

- JP 2014098633 A
- JP 2016006399 A